# EUROPEAN PATENT APPLICATION

(11) **EP 4 815 639 A1**
(43) Date of publication of application: **30.09.2026**
(21) Application number: 26166619.2
(22) Date of filing: 23.03.2026
(51) Int. Cl.: H05K 1/02, H05K 3/46

(54) **A DUMMY BODY EMBEDDED IN A COMPONENT CARRIER**

(30) Priority: 25.03.2025 CN 202510363275
(71) Applicant: AT&S (Chongqing) Company Limited, Chongqing 401133 (CN)
(72) Inventor: WU, Yuhui, 32845 Taoyuan City (TW)
(74) Representative: Dilg, Haeusler, Schindelmann Patentanwaltsgesellschaft mbH

(57) **Abstract**

There is described as a component carrier including: a stack of at least one electrically conductive layer structure and a plurality of electrically insulating layer structures, a dummy body embedded in a free region that is free of the at least one electrically conductive layer structure in the stack.

## Description

### Field of the Invention

The present invention relates to a component carrier, and a method of manufacturing a component carrier.

### Technical Background

In the context of growing product functionalities, component carriers are now equipped with one or more electronic components. Simultaneously, miniaturization continues to advance, along with a rising number of components to be mounted on or embedded in the component carriers like printed circuit boards. As a result, a construction height (typically referred to as an overall thickness dimension) reduction has become a trend, leading to thinner dielectric layers. However, this reduction in overall thickness can lead to insufficient dielectric materials, such as resin, failing to properly (or fully) fill lower-density areas around electrically conductive structures like copper. Consequently, this can cause bubble formation in these lower-density copper areas after lamination, thereby increasing the risk of delamination due to inadequate resin coverage.

Moreover, component carriers are often designed with areas or regions that are (kept) free of electrically conductive layer structures, known as metal-free zones, for several important reasons. For example, such metal-free zones allow for specific functionalities, thermomechanical adjustments, and other critical aspects of the design, such as ensuring a signal isolation (or transmission), providing a thermomechanical stability, or accommodating mounting holes (or components).

However, during the manufacturing process, particularly during lamination, improper control of temperature and/or mechanical pressure can lead to incomplete adhesion between layers, resulting in bubbles-like formation. These bubbles are more likely to occur in the metal-free zone(s) of a component carrier, potentially causing serious reliability issues, such as warpage or delamination, if not properly addressed.

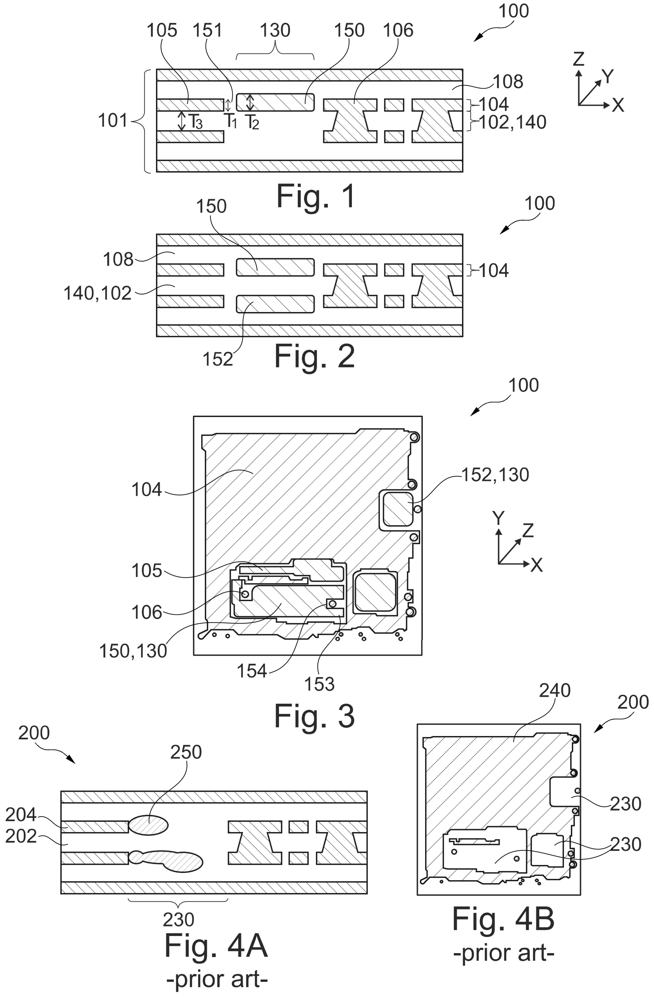

As such, an example of a conventional component carrier 200 with a metal-free region 230 is illustrated in **Figures 4A** and **4B****.**

**Figure 4A** illustrates a cross-sectional view of the conventional component carrier 200 having a multilayer laminated to one another. The multilayer comprises several electrically insulating layer structures 202 and several electrically conductive layer structures 204. The metal-free region 230 that is (kept) free of the electrically conductive layer structures 204 is arranged within the multilayer. As shown in Figure 4A, several bubbles 250 are present in the metal-free region 230.

**Figure 4B** illustrates a top view of the conventional component carrier 200 with a plurality of metal-free regions 230 distributed among the electrically conductive layer structures 204. In this scenario, the presence of bubbles 250 (as illustrated in Figure 4A) can lead to significant electrical problems such as increased impedance, signal loss, or short circuits.

Therefore, effectively providing the metal-free zone(s) in a component carrier remains a critical challenge in the manufacturing process, in particular regarding minimizing or eliminating the bubble formation.

### Summary of the Invention

There may be a need to provide an efficient and reliable component carrier, in particular with respect to high functionality.

A component carrier and a method of manufacturing a component carrier according to the present application are provided.

According to an exemplary embodiment of the invention, a component carrier (e.g. a printed circuit board, an IC substrate, an interposer) is provided, which comprises:
i) a stack comprising at least one electrically conductive layer structure and a plurality of electrically insulating layer structures,
ii) a free region (for example a metal-free zone), being (kept) free of (metal material of) the at least one electrically conductive layer structure, and
iii) a dummy body (for example an electrically insulating dummy body, in particular made of an at least partially, preferably fully, cured material such as a cured resin), wherein the dummy body is embedded in the stack, wherein the dummy body is provided on or in at least one of the plurality of electrically insulating layer structures, and wherein the dummy body fills the free region (partially or fully).

According to another exemplary embodiment of the invention, a method of manufacturing a component carrier is provided, wherein the method comprises:
i) forming a stack comprising at least one electrically conductive layer structure and a plurality of electrically insulating layer structures,
ii) defining a free region (for example a metal-free zone), being (kept) free of the at least one electrically conductive layer structure, and
iii) embedding a dummy body (for example an electrically insulating dummy body, in particular made of an at least partially, preferably fully, cured material such as a cured resin) in the stack, wherein the dummy body is provided on or in at least one of the plurality of electrically insulating layer structures, and wherein the dummy body fills the free region.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat. In addition, a stacked body may include a first (top) main surface and a second (bottom) main surface that are opposed to each other in a stacking direction. The stacking direction (also referring to a thickness direction of the stack) is substantially perpendicular to a main extension of the stacked body.

In the context of the present document, the term "layer structure" may particularly denote one of a continuous layer, a patterned layer and an arrangement of multiple connected and/or non-connected islands within one common plane. For instance, such a layer structure may be a continuous foil or sheet, whereas such a foil or sheet may also be patterned.

In the context of the present document, the term "free region" may particularly denote a region, area, portion or zone that may be (kept) free of electrically conductive layer structures (e.g., traces, vias, pads, blocks, etc.) in a component carrier. For instance, such a free region may preferably refer to a metal-free zone in the component carrier, which may be specifically designed to enhance the performance (and/or functionality) of the component carrier. In particular, the free region may act as a functional region, such as a designated area or zone within a PCB layout, that may be dedicated to some specific functional design or purpose. For example, this free region may be intentionally kept free of electrically conductive layer structures to prevent electromagnetic interference (EMI) and thereby reduce signal degradation between (at least) two adjacent elements (e.g., electronic components). Particularly in high-frequency or high-speed applications, arranging one or more free regions can ensure a reliable operation, such as eliminating unwanted coupling or interference, thereby enhancing the performance of the component carrier. Alternatively, the free region may be provided as a recess or cavity (e.g., a cutout of the stack) that is shaped and dimensioned to receive an electrically insulating dummy body (as described below).

In the context of the present document, the term "dummy body" may particularly denote an electrically insulating dummy body. For example, the dummy body may particularly refer to a non(electrically)-conductive material or structure that may be typically used as an electrical isolation structure between individual conductive elements. In particular, such an electrically insulating dummy body may act as a functional spacer, such as a physical structure or component within a PCB assembly, that may provide some specific functional properties or benefits to the overall component carrier. For example, an electrically insulating dummy body may comprise a low-dielectric material (e.g., a low Dk, dielectric constant and/or a low Df, dissipation factor) that can ensure an efficient signal transmission therethrough with a minimal attenuation and distortion. Alternatively (or additionally), an electrically insulating dummy body may be utilized as a thermal-resistance structure, ensuring that heat-sensitive regions or devices are effectively isolated while maintaining an optimized or minimized thermal stress between the layer structures. This may not only ensure a high functionality but also a high reliability of the component carrier, which is critical for applications requiring stable and reliable operation over time, such as high-power, high-frequency, or thermally demanding applications.

According to an exemplary embodiment, the invention may be based on the idea that a (highly functional) component carrier can be provided in an efficient and reliable manner, when the component carrier is provided with one or more electrically insulating dummy bodies embedded in the stack, especially in a free region (for example a metal-free zone) that is (kept) free of electrically conductive layer structures in the stack. In this manner, a reliable and robust component carrier structure with a high functionality can be obtained.

Such an electrically insulating dummy body may serve as a functional spacer arranged between electrically conductive portions of at least one electrically conductive layer structure. The provision of the electrically insulating dummy body in such a configuration may allow or ensure a high signal integrity and a minimal degradation, caused by factors such as crosstalk, impedance mismatch, and signal reflection, between assembly components (or circuits) in the component carrier, in particular electrically coupled to the electrically conductive portions in the proximity of the free region. Therefore, it can provide or enable a high protection and shielding of assembly components (or circuits) in the component carrier, thus ensuring a reliable performance especially for high-speed, high-frequency, or sensitive applications.

Moreover, this electrically insulating dummy body may be specifically adapted with the described configuration(s) for optimizing or minimizing a thermal and/or mechanical (including an internal residual stress and/or external mechanical loads) stress in the stack. More specifically, the provision of the electrically insulating dummy body with an appropriate configuration (for instance in terms of a compliant thermal expansion mismatch material on purpose, a balanced (or symmetrical) layer stack, etc.) may optimize a distribution of the thermal and/or mechanical stress in the stack, thus material stresses may be (possibly) avoided. This can efficiently prevent damage of the layer structures and delamination of the stack.

Furthermore, this approach may also enable a low manufacturing cost and a great design flexibility (simply) by adjusting materials with adaptable properties (for instance in terms of a coefficient of thermal expansion, CTE, a dielectric constant, etc.) and/or configuring layers (preferably a balanced or symmetric configuration) for optimal performance.

### Exemplary Embodiments

In the following, further exemplary embodiments of the component carrier and the method will be explained.

In an embodiment, a further electrically insulating layer structure of the plurality of electrically insulating layer structures is provided on and in contact with the at least one electrically conductive layer structure and the dummy body. For instance, the further electrically insulating layer structure may (directly) cover the at least one electrically conductive layer structure and the dummy body. In this case, the dummy body may be sandwiched between the at least one electrically insulating layer structure on the one hand and the further electrically insulating layer structure on the other hand. Such a sandwich-like configuration may have an advantage that the embedded dummy body can serve as a buffer layer structure between two (in particular two different) electrically insulating layer structures if designed appropriately. For example, the (intermediate) buffer layer structure may transfer a part of thermal and/or mechanical stress from the at least one electrically insulating layer structure provided thereunder (e.g., an internal layer structure) possible into the (outer) further electrically insulating layer structure (and/or an outer structure) provided thereon.

Alternatively, such a sandwich-like configuration may also provide a high protection and shielding of assembly components (or circuits) inside the stack, in particular accommodated underneath the at least one electrically insulating layer structure. For example, the dummy body may act as a moisture-resistant or flame-retardant barrier, which can protect the underlying components (or circuits) from moisture, fire or other harsh conditions. By way of examples, a reliable component carrier structure can be obtained.

In a further embodiment, the further electrically insulating layer structure is arranged on and in contact with the at least one electrically insulating layer structure. For example, the further electrically insulating layer structure may be further laminated onto the at least one electrically insulating layer structure and formed as a topmost layer structure of the plurality of electrically insulating layer structures. The further electrically insulating layer structure may include any electrically insulating, thermally conductive material or combination of materials.

In some embodiments, the further electrically insulating layer structure can be formed from the same material as the at least one electrically insulating layer structure or, in particular, from a different material. In the present embodiment, the further electrically insulating layer structure may extend over an entire upside of the at least one electrically insulating layer structure. The material and a layer thickness of the further electrically insulating layer structure can be chosen such that an appropriate material property (for example a comparatively high dielectric property or a comparatively low CTE) can be obtained in comparison with the at least one electrically insulating layer structure. Advantageously, the material costs for meeting specific design requirements can be reduced in a beneficial way.

In an embodiment, the dummy body is arranged in the free region of the at least one electrically conductive layer structure and is spaced in a horizontal direction from the at least one electrically conductive layer structure. As described herein, the horizontal direction may generally refer to a direction being parallel to a main extension of the component carrier. For instance, the dummy body may be placed in the free region and physically (or structurally) isolated from the at least one electrically conductive layer structure. More specifically, the dummy body may partly (in particular mostly) fill the free region and be separated from the at least one electrically conductive layer structure with a certain distance (or spacing) along the horizontal direction. Therefore, the dummy body may be placed or inserted into the free region in a flexible and easy manner (for example by a simple pick-and-place process). Preferably, the dummy body may be directly printed into the free region without requiring lamination or a lamination press for layer bonding. For example, the printed dummy body can be simultaneously cured (e.g., using a laser beam) without interfering with (e.g., independently of) the patterning process of the at least one electrically conductive layer structure. This approach may also enhance a flexibility of forming the dummy body into the free region.

In an alternative embodiment, the dummy body may fully fill the free region. In this embodiment, the dummy body may extend substantially over the entire volume of the free region with a large occupation. This may provide an improved protection and shielding of assembly components (or circuits) when electrically (and/or thermally) coupled to the at least one electrically conductive layer structure.

In addition to or as an alternative to the configuration of the free region as described above, it is for instance also possible to provide the free region as a recess or cavity in the at least one electrically insulating layer structure that is sized and shaped to receive the dummy body. Such a recess or cavity may be dimensioned so that a deliberate (or intentional) gap (or interspace) may be formed between the dummy body and the at least one electrically conductive layer structure along the horizontal direction. Therefore, the dummy body may be placed or inserted into the free region (e.g., a predetermined recess or cavity) in a flexible and easy manner (for example by a simple pick-and-place process). This approach may additionally enable a flexible printing of the dummy body directly into the free region without interfering with the patterning process.

In a further embodiment, at least part of a material of the further electrically insulating layer structure is arranged between the dummy body and the at least one electrically conductive layer structure, in particular along the horizontal direction. For instance, the dummy body may be physically (or structurally) isolated from the at least one electrically conductive layer structure by an interposition of a part of the further electrically insulating layer structure along the horizontal direction. More specifically, at least part of the material of the further electrically insulating layer structure may fill into the (above mentioned) deliberate (or intentional) gap formed between the dummy body and the at least one electrically conductive layer structure along the horizontal direction. In this manner, the at least one electrically conductive layer structure may be further protected without being influenced or disturbed by the dummy body when acting as a functional spacer. In addition but preferably, an integral structure may be accomplished by an interposition (or connection) of the electrically insulating material therebetween. Thus, a reliable and robust component carrier structure can be obtained.

In an embodiment, at least part of the further electrically insulating layer structure protrudes into a space between the dummy body and electrically conductive portions of the at least one electrically conductive layer structure besides the dummy body. For example, the at least part of the further electrically insulating layer structure may extend along the circumferential sidewalls of the dummy body facing the electrically conductive portions of the at least one electrically conductive layer structure. In other words, the dummy body and the electrically conductive portions of the at least one electrically conductive layer structure may be spaced from one another along the horizontal direction by the material of the further electrically insulating layer structure. Additionally or preferably, the at least part of the further electrically insulating layer structure may fully fill the gap so that it can be in direct contact with the (above-mentioned) electrically insulating layer structure in the gap. As a result, the electrically conductive portions of the at least one electrically conductive layer structure may be further protected without being influenced or disturbed by the dummy body when acting as a functional spacer. This may offer a flexible design of the component carrier in an advantageous way.

In an embodiment, the dummy body occupies a majority of a volume defined by the free region along a thickness (T1) of the at least one electrically conductive layer structure. As described herein, a thickness direction may particularly refer to a direction being perpendicular to the main extension of the component carrier. For example, the dummy body may mostly fill the free region and extend vertically along the at least one electrically conductive layer structure. Alternatively, the dummy body may fully fill the free region and substantially extend the entire thickness (T1) of the at least one electrically conductive layer structure. As such, the dummy body may offer an improved functionality and also reliability for the component carrier due to a larger occupation.

In an embodiment, the dummy body has a thickness (T2) being less than a sum of the thickness (T1) of the at least one electrically conductive layer structure and a thickness (T3) of one of the plurality of electrically insulating layer structures. In other words, the dummy body may have the thickness dimension satisfying a relationship of T2 < (T1 + T3). Preferably, under such thickness relationship, two opposing main surfaces of the dummy body may vertically extend over or protrude above that of the at least one electrically conductive layer structure. As a result, a high protection and shielding of the at least one electrically conductive layer structure may be obtained particularly when high-heat (and/or high-sensitive) components electrically coupled thereto.

In particular, the dummy body may have a thickness (T2) equal or less than the thickness (T1) of the at least one electrically conductive layer structure. Preferably, two opposing main surfaces of the dummy body may be coplanar with (or aligned with) that of the at least one electrically conductive layer structure, respectively. Advantageously, the dummy body may have such thickness to (simply) follow the profile of the free region as confined (or delimited) by the at least one electrically conductive layer structure having similar thickness. Therefore, this may not only facilitate an easy manufacturing process without filling the free region over or less, but also provide an effective protection and shielding of the at least one electrically conductive layer structure when assembly components (or circuits) electrically coupled thereto.

In an embodiment, at least one main surface of the dummy body does not flush with a main surface of the at least one electrically insulating layer structure and/or one of the plurality of electrically insulating layer structures. For instance, at least one main surface of the dummy body may extend upward to or even protrude beyond a surface of one of the plurality of electrically insulating layer structures. As a result, the at least one electrically conductive layer structure may be effectively protected and shielded by the dummy body. This may also offer a flexible design of the dummy body and the component carrier in an advantageous way.

In an embodiment, the further electrically insulating layer structure has a thickness smaller than five times, in particular three times, more in particular two times, the thickness (T1) of the at least one electrically conductive layer structure. By such configuration, warpage and the overall thickness of the component carrier may be further reduced in a simple and flexible manner.

In an embodiment, the at least one electrically conductive layer structure is a discontinuous layer structure comprising electrically conductive portions. For instance, the at least one electrically conductive layer structure may be patterned to have a plurality of electrically conductive portions, in particular with an ever small spacing between thereof. The electrically conductive portions may be distributed within and/or over the plurality of electrically insulating layer structures. In some embodiments, the electrically conductive portions may include one or more active or passive components electrically coupled thereto. This may enable a high functionality of the component carrier while maintaining a compact construction.

In a further embodiment, the dummy body is arranged between at least two of the electrically conductive portions. In the present embodiment, the at least two of the electrically conductive portions may be spaced from one another, in particular along the horizontal direction. Preferably, the planar distance (in the horizontal direction) between (the at least) two electrically conductive portions may be larger than 5 mm. In this regard, the dummy body may be placed between, preferably symmetrically or centrally placed with, the at least two of the electrically conductive portions. By taking this measure, the mechanical stress between the at least two of the electrically conductive portions can be effectively balanced, thereby efficiently preventing delamination between the at least one electrically conductive layer structure and the at least one electrically insulting layer structure. That is also to say, the presence of the dummy body can improve the mechanical matching between the (at least two) electrically conductive portions adjacent thereto and the electrically insulating material, in comparison to an example in which the dummy body may be not formed therein.

On the other hand, the dummy body may act as a functional spacer between the at least two of the electrically conductive portions adjacent thereto. Such a functional spacer can provide some specific functional properties to enhance the performance of the component carrier. For example, the dummy body may act as a (specific) dielectric structure having a locally increased dielectric property (e.g., a high Dk) which can provide an effective electrical and/or signal isolation for assembly components electrically coupled thereto. In particular, this may effectively reduce signal loss and improve signal integrity in high-speed or high-frequency applications. Alternatively, the dummy body may comprise a different material from a base material of the stack, such as a low Dk and/or a low Df resin, thereby ensuring a highly enhanced signal performance in the component carrier.

In another example, the dummy body may act as a thermal-isolation barrier (e.g., comprising ceramics, glass fiber or polymers) between the at least two of the electrically conductive portions when high-heat (and/or high-sensitive) devices electrically coupled thereto. That is, the high-heat (and/or high-sensitive) devices are physically and thermally isolated from one another by providing thermal-isolation barriers spaced along the horizontal direction. In this way, the heat flow will be effectively directed along a vertical path from internal layers to external structures (e.g., a heat sink) and/or ambient air, thereby minimizing thermal interference effects of multiple devices.

In an embodiment, the dummy body partially surrounds at least one of the electrically conductive portions of the at least one electrically conductive layer structure, in particular wherein the dummy body and the electrically conductive portions are spaced by electrically insulating material. As similar to the embodiment described above, the surrounding at least one of the electrically conductive portions may be further protected by the electrically insulating material while maintaining an integral structure.

In an embodiment, the dummy body comprises a planar profile. In particular, the planar profile may run in a plane parallel to the main extension of the component carrier (i.e., perpendicular to the stacking direction). The planar profile may have a plurality of different shapes, including but not limited to standard (two-dimensional) geometric shapes like a rectangle, triangle or circle. In this case, the dummy body can properly fit the profile of the free region (in particular a specific or unique space) that is defined as being free of the at least one electrically conductive layer structure. As a result, the dummy body may be flexibly adapted within a non-standard or complex layout of the component carrier, which can provide greater design freedom.

More specifically, the dummy body with some desired shapes can be directly printed within the free region, and its spatial distribution can be automatically optimized or enhanced by a controlled printing module. Advantageously, this may not only ensure an efficient material allocation but also improve the structural integrity of the dummy body formation with less design constraints.

In a further embodiment, the planar profile comprises at least one concave portion that partially surrounds at least one of the electrically conductive portions. As such, the surrounding at least one of the electrically conductive portions may be highly protected and shielded by the at least one concave portion of the dummy body.

In some embodiments, the dummy body is plate-shaped, in particular comprising two opposed main surfaces. The dummy body may be shaped in such a way that a plate-shaped (or flat) structure has a cross-sectional enlargement of a main body parallel to the main extension of the component carrier. Alternatively, the dummy body may be embodied in a strip- or web-shaped manner. By example of the latter, they may also be shaped as a lattice- or grid-like structure having an increased cross-sectional area (in particular with a compatible surface roughness). In this way, they can allow for a homogenous (or optimized) distribution of mechanical loads, further improving the mechanical matching therebetween, for example, material stresses can be avoided.

In a further embodiment, the dummy body may have a top main surface and a bottom main surface opposite to the top main surface. Meanwhile, the dummy body may comprise circumferential sidewalls formed by parallel straight lines, in particular by slanted lines. This may also allow for an improved distribution of mechanical loads and reduced material stresses. As a result, during lamination delamination or warpage can be eliminated, thereby leading to an improved reliability of the component carrier.

In an embodiment, the dummy body is embedded, in particular sandwiched, between two of the plurality of electrically insulating layer structures. In other words, the dummy body is fully enclosed by electrically insulating material of the plurality of electrically insulating layer structures of the stack. More specifically, the dummy body may be completely embedded or enclosed on all sides thereof by material of the plurality of electrically insulating layer structures. Preferably, one main surface and circumferential sidewalls of the dummy body may be completely covered by or directly bonded to the material of the further electrically insulating layer structure. Combining such arrangement with above described one or more configurations, it may offer a flexible design of the component carrier that is capable of achieving a high performance while maintaining a high reliability.

In an embodiment, the free region is an active portion of the stack, wherein the dummy body is embedded in the active portion of the stack. In some embodiments, the free region may be a structured functional region for accommodating a passive component (e.g., a capacitor) or guiding a signal transmission therein. For example, the embedded dummy body may comprise an appropriate dielectric material (e.g., a dielectric ceramic layer structure) that can be used as a capacitor when integrated with the at least one electrically conductive layer structure (e.g., acting as electrodes). Alternatively, the embedded dummy body may act as a dielectric waveguide that can confine and direct electromagnetic waves particularly for microwave and optical applications.

In a preferable embodiment, a density of electrically conductive portions in the proximity of the dummy body and/or the free region is lower than in other regions of the stack. Accordingly, some specific components (for example high-sensitive, high-power or high-heat components) can be (intentionally) adapted to be electrically (and/or thermally) coupled to the low density of the electrically conductive portions. Advantageously, this may improve or optimize the performance of the overall component carrier. Additionally, arranging a low density of the electrically conductive portions in the proximity of the dummy body may have an advantage that the material stresses (i.e., the thermal and/or mechanical stress) therearound can be effectively reduced or minimized by the presence of the adjacent dummy body thereto. This may further ensure a reliable component carrier.

In an alternative embodiment, the at least one electrically insulating layer structure is configured as a core layer, wherein the dummy body is in contact with the core layer. Such a core layer may be a robust structure suitable for placing one or more electrically insulating dummy body(s) therein (or thereon). As such, the dummy body may be provided on or in the core layer in a stable and efficient manner.

In an embodiment, the component carrier comprises at least two dummy bodies, wherein one of the plurality of electrically insulating layer structures, in particular the core layer, is sandwiched by the at least two dummy bodies. For example, the at least two dummy bodies may be arranged for vertically sandwiching the core layer in between.

In another embodiment, at least two dummy bodies may be embedded in the same electrically insulating layer structure and/or at least partially on top of each other in the vertical direction. In particular, the at least two dummy bodies may be vertically spaced only by at least part of one of the plurality of electrically insulating layer structures, in particular the core layer. For instance, the at least two dummy bodies may be placed vertically side-by-side to one another within the (same) further electrically insulating layer structure and separated along the stacking direction by the core layer. In this regard, arranging the at least two dummy bodies on both opposing main surfaces of the core layer may further improve the thermomechanical performance and thus the overall reliability of the component carrier, since undesired effects such as thermal stress and consequently undesired phenomena such as warpage may be strongly suppressed.

In an embodiment, the dummy body comprises a material different to the material of the plurality of electrically insulating layer structures. Preferably, the dummy body may comprise a material having a lower CTE than that of the plurality of electrically insulating layer structures, in particular the at least one electrically insulating layer structure. In this case, the dummy body, for example acting as a buffer layer structure, may optimize or even minimize the effects (or differences) of thermal expansion mismatch between the surrounding electrically conductive portions and the plurality of electrically insulating layer structures (in particular the at least one electrically insulating layer structure). As a result, this may enable reduced thermal stresses, thereby reducing warpage or delamination.

Alternatively, the dummy body may comprise a conductive material. More specifically, the dummy body may comprise or consist of a material similar to (or identical to) that of the at least one electrically conductive layer structure. For example, the dummy body may be formed by a metal body, such as a metal block, plate or the like. Additionally, the dummy body may also comprise or consist of a mixture of a conductive material and an insulating material, such as a metal-resin joined body. By way of examples, these configurations may not only provide an enhanced mechanical support but also ensure an improved thermal behavior, particularly with respect to the CTE. More advantageously, by matching or closely aligning the CTE of the dummy body with that of the at least one electrically conductive layer structure, thermal stresses can be minimized, thereby preventing warping or delamination. As a result, the overall reliability and durability of the component carrier structure can be significantly improved.In an embodiment, the at least two dummy bodies comprise a (similar or) different material, in particular with respect to a resin and/or a filler and/or a cured state. For example, the at least two dummy bodies may comprise a different material property (for instance in terms of thermal expansion, dielectric constant, glass transition temperature, Tg, etc.) from that of the electrically insulating material, in particular from the core layer. For example, the at least two dummy bodies may have a comparatively lower CTE than that of the (intermediate) core layer. Preferably, the CTEs of the individual layer structure may be selected in such a way that the CTE is asymmetrical, in particular essentially symmetrical or as symmetrical as possible, when viewed along the stacking direction. As such, this may highly reduce thermal stress in an advantageous way. In an alternative (or additional) example, the material of the at least two dummy bodies may have a higher glass transition temperature (Tg) compared to the electrically insulating material. In this regard, the at least two dummy bodies may ensure a high stiffness (e.g., more rigidity), thereby providing a high stability and mechanical reinforcement to the overall component carrier structure.

Alternatively (or additionally), the at least two dummy bodies may have a different material property from one another, that is, may have a different material property with a different functionality from one another. As a result, a symmetric configuration with a high (multi-)functionality may be obtained.

In an embodiment, the dummy body is provided (during manufacture) as a cured resin, reflected in the (final) component carrier structure by an interface region of the dummy body and the surrounding electrically insulating material. In other words, the interface region may be reflected from the manufacture process during which two different materials and/or curing states were used. In an embodiment, during the manufacturing of the component carrier, the dummy body may be provided as a (fully) cured resin, while the electrically insulating material may be provided as an uncured (or semi-cured) resin. In the final product, after solidification of both resins, the interface region therebetween may clearly indicate the manufacture process.

In one embodiment, the plurality of electrically insulating layer structures may comprise a further electrically insulating layer structure, the further electrically insulating layer structure is semi-cured before being laminated onto the at least one electrically conductive layer structure and/or one of the plurality of electrically insulating layer structures. For example, the (semi-cured) further electrically insulating layer structure may be pre-prepared to be directly bonded to the at least one electrically conductive layer structure and/or one of the plurality of electrically insulating layer structures. Therefore, an integral and reliable configuration may be enabled.

In a further embodiment, the further electrically insulating layer structure is pressed into a free space in the semi-cured state (formed between the dummy body and the at least one electrically conductive layer structure). Accordingly, one main surface and circumferential sidewalls of the dummy body may be surrounded by the further electrically insulating layer structure. This thereby may offer a reliable component carrier with a high performance in an easy and stable manner.

In an embodiment, the further electrically insulating layer structure comprises a resin to at least partially embed the dummy body, in particular wherein embedding is done with the further electrically insulating layer structure in the semi-cured state and/or the dummy body in the cured state. Thereby, an efficient and reliable embedding process for the dummy body may be enabled.

In an embodiment, the component carrier is shaped as a plate. This contributes to the compact design, wherein the component carrier nevertheless provides a large basis for mounting components thereon. Furthermore, in particular a naked die as an example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the plurality of electrically insulating layer structures comprise at least one of the group consisting of resin (such as rein-forced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structures.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type body. In such an embodiment, the semifinished product or the component carrier is a compound of multiple layer structures which are stacked and connected together by applying a pressing force, if desired accompanied by heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above, and further aspects of the invention are apparent from the examples of embodiment to be described hereinafter and are explained with reference to these examples of embodiment.
Figure 1 schematically illustrates a cross-sectional view of a component carrier including a stack with one embedded electrically insulating dummy body, according to an exemplary embodiment of the invention.
Figure 2 schematically illustrates a cross-sectional view of a component carrier including a stack with two embedded electrically insulating dummy bodies, according to an exemplary embodiment of the invention.
Figure 3 schematically illustrates a top view of a component carrier including a stack with a plurality of embedded electrically insulating dummy bodies, according to another exemplary embodiment of the invention.
Figures 4A and 4B respectively depict a cross-sectional view and a top view of a conventional component carrier.

### Detailed Description of the Drawings

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a (highly) reliable component carrier is provided with a high functionality which is realized by one or more embedded dummy bodies. This enables a greater design flexibility and an easier manufacturing process with a low manufacturing loss. More specifically, such an architecture with embedded dummy bodies into the component carrier stack, in particular a free region (for example a metal-free zone) in the active portion of the stack, during lamination allows or enables a high protection and shielding of assembly components (or circuits) in the component carrier, in particular electrically (and/or thermally) coupled to the at least one electrically conductive layer structure in the proximity of the free region.

Due to the increasing requirement of miniaturization, the overall thickness of the component carrier, especially the insulating layer, has to be reduced. When thinner insulating material is laminated onto the (discontinuous) conductive layers, this reduction in thickness can lead to insufficient dielectric materials, such as resin, failing to properly (or fully) fill lower-density areas around electrically conductive structures like copper. Consequently, this can cause bubble formation in these lower-density copper areas after lamination, thereby increasing the risk of delamination due to inadequate resin coverage. By applying the dummy body in such lower-density area, the bubble issue may be completely avoided.

Moreover, it is possible to reduce or even minimize a mechanical stress (for instance a residual stress and/or external mechanical loads) in the stack due to resin and/or adhesive shrinkage. Furthermore, a thermal stress (for instance a coefficient of thermal expansion mismatch) between electrically insulating material and electrically conductive layer structures (or embedded components) may be reduced or even minimized. It is further possible to embed different dummy bodies in such a free region with an appropriate configuration for a highly improved distribution of the thermal and/or mechanical stress inside the stack, thereby efficiently preventing delamination or warpage of the stack.

**Figure 1** illustrates a cross-sectional view of an exemplary component carrier 100 including a stack 101 with one embedded dummy body 150.

In general, the component carrier 100 (such as a printed circuit board or an IC substrate) includes the stack 101 that comprises at least one electrically conductive layer structure 104 and a plurality of electrically insulating layer structures 102, 108. The at least one electrically conductive layer structure 104 may include a regular conductor pattern such as copper, gold, silver, aluminium or an alloy thereof. The plurality of electrically insulating layer structures 102, 108 may include an insulating resin, a prepreg or a composition thereof. The plurality of electrically insulating layer structures 102, 108 and the at least one electrically conductive layer structure 104 are laminated together under heat and/or mechanical pressure. For example, the plurality of electrically insulating layer structures 102, 108 may be a continuous layer where the at least one electrically conductive layer structure 104 may be embedded therein. In another example, processes such as etching, milling, laser drilling, and /or the like may be implemented to create the at least one electrically conductive layer structure 104 within the plurality of electrically insulating layer structures 102, 108.

In some cases, at least one 102 of the plurality of electrically insulating layer structures 102, 108 may form a core layer 140 covered on both opposing main surfaces with the at least one electrically conductive layer structure 104. Also, the at least one electrically conductive layer structure 104 may be distributed within and/or through the core layer 140.

In the present context, the term "main surface" of a body may particularly denote one of two largest opposing surfaces of the body that extend along a main axis or dimension of the body.

As illustrated in Figure 1, a main surface of the component carrier 100 refers to a top main surface (e.g., facing the +Z direction of the coordinate axes of Figure 1) or a bottom surface (e.g., facing the -Z direction of the coordinate axes of Figure 1) parallel to a main extension of the component carrier 100 (e.g., along the X direction of the coordinate axes of Figure 1). The main surface(s) may be connected by circumferential sidewalls or edges.

In addition, the term "thickness" of the body, such as a layer stack, may particularly refer to a dimension that measures the distance between its two (largest) opposing main surfaces. In the case of the component carrier 100, as illustrated in Figure 1, a thickness may be defined as the distance measured perpendicular to the main extension of the component carrier 100 (e.g., along the Z direction of the coordinate axes of Figure 1).

Now referring to Figure 1, the at least one electrically conductive layer structure 104 is patterned or embedded within a base material of the plurality of electrically insulating layer structures 102, 108. The at least one electrically conductive layer structure 104 is a discontinuous layer structure comprising a plurality of electrically conductive portions 105, 106.

In this regard, the electrically conductive portions 105, 106 are embedded and distributed over the base material of the plurality of electrically insulating layer structures 102, 108. The electrically conductive portions 105, 106 may have an identical or different shape and/or dimension from one another. In some embodiments, the electrically conductive portions 105, 106 may be electrically coupled to one or more active or passive components (not shown in Figure 1).

Further, the electrically conductive portions 105, 106 are spaced apart from one another along a horizontal direction parallel to the main extension of the component carrier 100. In particular, the electrically conductive portions 105, 106 are spaced apart from one another along the horizontal direction at a spacing of 5 mm or more.

In the present context, the term "horizontal direction" of a body may particularly denote a line or plane that may be parallel to the main extension of the component carrier 100 (e.g., along the X direction of the coordinate axes of Figure 1). In addition, the term "vertical direction" of the body may particularly refer to a line or plane that may be perpendicular to the main extension of the component carrier 100 (e.g., along the Z direction of the coordinate axes of Figure 1).

As shown as well from Figure 1, the component carrier 100 includes a free region 130 that is defined as an area (e.g., a portion, volume, zone, or region) being free of the at least one electrically conductive layer structure 104. The free region 130 is formed on or in the stack 101, typically having an average area of 90 mm² or more.

As shown in Figure 1, the free region 130 is an area (or a free space) confined (or delimited) by two separate electrically conductive portions 105, 106 along the horizontal direction. In one example, a density of the electrically conductive portions 105, 106 per unit area (or volume) in proximity to the free region 130 may be lower than a density of other portions of the at least one electrically conductive layer structure 104 distant from the free region 130. According to the present embodiment, the free region 130 is a functional region of the stack 101, such as for an electrical and/or signal isolation, for embedding or assembling a heat-resistant (and/or flame-retardant or moisture-resistant) system or the like. Such implementation of a free region 130 within the stack 101 allows for low manufacturing costs and a great design flexibility.

As further illustrated in Figure 1, the component carrier 100 includes one dummy body 150 that is embedded in the stack 101. Specifically, the dummy body 150 partly or completely fills the free region 130 of the stack 101. More specifically, the dummy body 150 partly or completely fills or occupies a volume (e.g., the free area or space described above) defined by the free region 130.

The dummy body 150 may have an elongate shape (e.g., a strip-like shape or a plate-like shape) and be oriented along the horizontal direction. In some embodiments, the dummy body 150 may have substantially vertical sidewalls, preferably having slanted and/or tapered sidewalls. By way of latter examples, the mechanical stress will be partially released or redirected along the horizontal direction.

In another example, the free region 130 may be referred to as dummy regions suitable for one or more dummy bodies 150 insertion. In such case, the dummy regions located in the proximity to the electrically conductive portions 105, 106 are filled with a material of the dummy body 150. In some embodiments, the dummy body 150 may comprise a functional insulation material, such as a functional spacer, with characteristics such as heat resistance, weather resistance, fireproofing, water resistance and/or the like. Also, composite material may be employed depending on requirements. Thereby, a configuration with a high (multi-)functionality can be obtained.

Still referring to Figure 1, the dummy body 150 is provided on at least one electrically insulating layer structure 102. Further, the dummy body 150 is placed between two separate electrically conductive portions 105, 106 along the horizontal direction. Specifically, a bottom main surface of the dummy body 150 is directly (and entirely) contacted with the at least one electrically insulating layer structure 102. In one example, two opposing main surfaces of the dummy body 150 may be, respectively, aligned substantially coplanar with that of the electrically conductive portions 105, 106 along the horizontal direction. Alternatively, the dummy body 150 may have a thickness (T2) equal to or less than, preferably more than, a thickness of the electrically conductive portions 105, 106 (T1) along the vertical direction.

Further, the component carrier 100 includes a further electrically insulating layer structure 108 that is provided on the at least one electrically insulating layer structure 102. As shown in Figure 1, the further electrically insulating layer structure 108 is provided on and in direct contact with the at least one electrically conductive layer structure 104 and the dummy body 150. At least part of the further electrically insulating layer structure 108 is arranged between the at least one electrically conductive layer structure 104 and the dummy body 150 along the horizontal direction. Specifically, a part of material of the further electrically insulating layer structure 108 protrudes or fills into a space 151 formed between the dummy body 150 and at least one of the electrically conductive portions 105, 106 along the horizontal direction. Alternatively or additionally, the at least part of the further electrically insulating layer structure 108 may fully fill the gap 151 so that it can be in direct contact with the at least one electrically insulating layer structure 102 in the gap 151. In other words, the top main surface and circumferential sidewalls of the dummy body 150 are (directly and entirely) covered by the material of the further electrically insulating layer structure 108. In a general example, at least one main surface (including circumferential sidewalls) of the dummy body 150 may be (directly and entirely) covered by the material of the further electrically insulating layer structure 108.

It is preferable that the material of the dummy body 150 may have a similar coefficient of thermal expansion as the material of the further electrically insulating layer structure 108. Further, the material of the dummy body 150 may have a lower coefficient of thermal expansion than the material of the at least one electrically insulating layer structure 102. As a result, the dummy body 150 may minimize the effects of thermal expansion mismatch between the electrically insulating material and the at least one electrically conductive layer structure 104 adjacent thereto. More preferably, the dummy body 150 may be formed by a conductive material (for example a metal body or a metal-resin joined body) and may have a similar material property to that of the at least one electrically conductive layer structure 104. More specifically, the material of the dummy body 150 may have an in-plane coefficient of thermal expansion closely matched to that of the at least one electrically conductive layer structure 104. Thereby, a configuration with a highly reduced thermal stress may be obtained, significantly reducing warping or delamination.

**Figure 2** illustrates a cross-sectional view of a component carrier 100 with two dummy bodies 150, 152 embedded within a stack 101, according to an exemplary embodiment of the invention.

As illustrated in Figure 2, the two dummy bodies 150, 152 are placed on and in direct contact with two opposing main surfaces of the aforementioned core layer 140. In other words, the core layer 140 is sandwiched between the two separate dummy bodies 150, 152 along the vertical direction. Further, one main surface and circumferential sidewalls of each of the two dummy bodies 150, 152 are (directly and entirely) covered by the material of the further electrically insulating layer structure 108.

The two dummy bodies 150, 152 may have an identical composition or a different material property from one another. In one example, they may be dimensioned identically (e.g., equal in size and placed opposite in direction) so that a symmetric configuration (in a balanced and mirror-like arrangement) can be obtained, as shown in Figure 2. Thereby, such symmetric configuration can optimize (or improve) stress distribution, which contributes to an enhanced release of mechanical stress, ultimately preventing warpage or deformation. Alternatively, the (at least) two dummy bodies 150, 152 may be provided and distributed asymmetrically among the electrically conductive portions 105, 106, in particular based on specific design and application requirements. In this regard, a high functionality of the component carrier can be provided in a flexible design.

Alternatively, it is possible that the dimensions of the two dummy bodies 150, 152 may be adjusted so that a space 151 (or a gap) remains minimized between the two dummy bodies 150, 152 and the electrically conductive portions 105, 106. In such an alternative embodiment, the space 151 is therefore still filled with the material of the further electrically insulating layer structure 108.

According to other possibilities, the two dummy bodies 150, 152 may comprise a plurality of dummy patterns that are located over the core layer 140 in a spaced-apart relationship to one another. The dummy patterns may be embedded within the stack 101 by, e.g., using the same techniques as for embedding one dummy body 150 within the stack 101 (shown in Figure 1). In a preferable example, the dummy patterns may be asymmetrically or symmetrically distributed on or over the stack 101, in particular among the electrically conductive portions 105, 106 adjacent thereto.

More specifically, the dummy patterns, e.g., the upper ones or lower ones, may be adjacent to one another and spaced by a part of the further electrically insulating layer structure 108 along the horizontal direction. In other words, the upper and lower dummy patterns may be, respectively, placed symmetrically over two opposing main surfaces of the core layer 140 in a horizontal plane. Alternatively, the upper and lower dummy patterns may be, respectively, placed asymmetrically over two opposing main surfaces of the core layer 140 in the horizontal plane.

Alternatively (or additionally), the upper and lower dummy patterns may be, accordingly, aligned substantially coaxial to one another over the core layer 140 in a vertical plane. The dummy patterns may all have the same shape, dimension, material composition and mutual distance from one another in the horizontal and vertical plane.

According to one possibility, the dummy patterns may comprise a different material from one another, e.g., may have a different material property with a different functionality. For example, a part of the dummy patterns may comprise a thermal-resistance material functioning as part of a cooling system. Another part of the dummy patterns may comprise a moisture-resistance material functioning as a barrier or protective structure that prevents the underlying components or circuits from damage caused by moisture or humidity exposure. As a result, a symmetric (or asymmetric) configuration with a high functionality and a high reliability can be obtained.

**Figure 3** illustrates further a top view of a component carrier 100 according to the embodiment relating to Figure 1 or Figure 2. In the present embodiment, a plurality (hereinafter referring to at least three) of dummy bodies 150, 152 are embedded within a stack 101.

As illustrated in Figure 3, the plurality of dummy bodies 150, 152 comprise a planar profile with different shapes, such as square, rectangle or polygon. In some embodiments, the planar profile may have a circular or annual ring shape depending on requirements. In one example, the planar profile may comprise an opening formed on the sidewalls to accommodate at least one of the electrically conductive portions 105, 106.

As further shown in Figure 3, the planar profile comprises at least one convex portion 153 and at least one concave portion 154 around the peripheral sides. The convex portion 153 and the concave portion 154 at least partially surround at least one of the electrically conductive portions 105, 106. In this regard, the surrounding at least one of the electrically conductive portions 105, 106 can be highly protected by the plurality of dummy bodies 150, 152.

The various embedded dummy bodies described herein should be generally understood. Now turning to a method of manufacturing an illustrative component carrier structure having an embedded electrically insulating dummy body, the following will be described in detail according to an exemplary embodiment of the invention. It should be noted that an illustrative example of a particular ordering of steps will be described herein, but the present disclosure is not limited to such an example.

In one example, a component carrier structure comprises constituents of a stack that are connected to one another through a known process, preferably by lamination, i.e., the application of heat and/or mechanical pressure. In general, the constituents of the stack comprise multiple (planar) electrically conductive layer structures and electrically insulating layer structures, so that the formed component carrier is a plate-shaped laminate type printed circuit board (PCB) component carrier. The electrically conductive layer structures are composed of patterned metal layers such as patterned copper foil and may also comprise vertical through connections such as copper filled laser vias. The electrically insulating layer structures may comprise sheets comprising resin (in particular epoxy resin), optionally comprising reinforcing particles (such as glass fibers or glass spheres) therein. For instance, the electrically insulating layer structures may be made of prepreg.

In a further example, a dummy body is embedded in the stack, in particular printed into an area (e.g., a region or portion) that is (kept) free of the electrically conductive layer structures. Hereinafter, such an area (region or portion) that is (kept) free of the electrically conductive layer structures is defined as a free region. The dummy body is essentially elongated in shape, in particular plate shaped, which is preferably made of at least partially cured (preferably fully cured) electrically insulating material such as a cured resin.

In this process, the dummy body is placed between two electrically conductive portions of the electrically conductive layer structures along the horizontal direction. In this regard, the dummy body is shaped and dimensioned so as to be insertable in the free region as well as maintain an interspace (or gap) between the dummy body and the individual electrically conductive portions after insertion. Preferably, the dummy body is directly printed into and fills the free region. Afterwards, the dummy body does not flush with, in particular extends below, an exterior main surface of the layer structures.

For ensuring that, a surface inspection by means of an optical inspection method (e.g., automated optical inspection or a visual reference system) is applied to the stack.

In a further step, a further electrically insulating layer structure, which may be made of resin, in particular a semi-cured resin, is laminated onto (or directly bonded to) the dummy body and the layer structures.

More specifically, the further electrically insulating layer structure is pressed to fill the interspace (or gap) formed between the dummy body and the individual electrically conductive portions, so that circumferential sidewalls of the dummy body are (directly and entirely) surrounded by a material of the further electrically insulating layer structure.

Afterwards, a curing process is applied to the overall structure of the component carrier.

In a final step, a further build-up (or lamination) is arranged on both opposing main surfaces of the processed stack, in particular symmetrically with one or more further electrically insulating layer structures and/or electrically conductive layer structures. This further build-up may include a surface finish or an encapsulation to protect and refine the component carrier structure.

In the above detailed description, reference is made to the accompanying drawings, which form a part thereof and in which are shown by way of illustration specific embodiments. In this regard, the term "over" employed in this description regarding a material layer (or layer structure) formed or located "over" a surface maybe used herein to mean that the material layer (or layer structure) be located (e.g. formed, positioned, etc.) "directly on", e.g., in a direct contact with, the implied surface.

As well, it should be noted that the term "comprising" does not exclude other elements or steps and the "a" or "an" does not exclude a plurality.

It should be also noted that reference signs in the claims should not be construed as limiting the scope of the claims.

Implementation of the invention is not limited to the preferred embodiments shown in the figures described above. Instead, a multiplicity of variants is possible which use the solutions shown and the principle according to the invention even in the case of fundamentally different embodiments.

### Reference signs

- 100: Component carrier
- 101: Stack
- 102: Electrically insulating layer structure
- 104: Electrically conductive layer structure
- 105, 106: Electrically conductive portions
- 108: Further electrically insulating layer structure
- 130: Free region
- 140: Core layer
- 150, 152: Dummy body
- 151: Free space
- 153: Convex portion
- 154: Concave portion

- 200: Conventional component carrier
- 202: (Conventional) electrically insulating layer structure
- 204: (Conventional) electrically conductive layer structure
- 230: (Conventional) metal-free region
- 250: Bubbles

## Claims

1. A component carrier (100), wherein the component carrier comprises:
a stack (101) comprising at least one electrically conductive layer structure (104) and a plurality of electrically insulating layer structures (102, 108);
a free region (130), being free of the at least one electrically conductive layer structure (104); and
a dummy body (150), wherein the dummy body (150) is embedded in the stack (101), wherein the dummy body (150) is provided on or in at least one of the plurality of electrically insulating layer structures (102, 108), and wherein the dummy body (150) fills the free region (130).

2. The component carrier (100) according to claim 1,
wherein a further electrically insulating layer structure of the plurality of electrically insulating layer structures (102, 108) is provided on and in contact with the at least one electrically conductive layer structure (104) and the dummy body (150).

3. The component carrier (100) according to claim 2,
wherein the further electrically insulating layer structure is arranged on and in contact with the at least one electrically insulating layer structure .

4. The component carrier (100) according to one of the preceding claims,
wherein the dummy body (150) is arranged in the free region (130) of the at least one electrically conductive layer structure (104) and is spaced in a horizontal direction from said at least one electrically conductive layer structure (104),
in particular wherein at least part of a material of the further electrically insulating layer structure is arranged between the dummy body (150) and said at least one electrically conductive layer structure (104), in particular along the horizontal direction.

5. The component carrier (100) according to claim 1 to 3,
wherein at least part of the further electrically insulating layer structure protrudes into a space (151) between the dummy body (150) and electrically conductive portions (105, 106) of the at least one electrically conductive layer structure (104) besides the dummy body (150); or
wherein the dummy body (150) fully fills the free region (130).

6. The component carrier (100) according to one of the preceding claims,
wherein the dummy body (150) occupies a majority of a volume defined by the free region (130) along a thickness (T1) of said at least one electrically conductive layer structure (104).

7. The component carrier (100) according to one of the preceding claims,
wherein the dummy body (150) has a thickness (T2) being less than a sum of the thickness (T1) of the at least one electrically conductive layer structure (104) and a thickness (T3) of one of the plurality of electrically insulating layer structures (102, 108),
in particular wherein the dummy body (150) has a thickness (T2) equal or less than the thickness (T1) of the at least one electrically conductive layer structure (104).

8. The component carrier (100) according to one of the preceding claims,
wherein at least one main surface of the dummy body (150) does not flush with a main surface of the at least one electrically insulating layer structure and/or one of the plurality of electrically insulating layer structures (102, 108).

9. The component carrier (100) according to one of the preceding claims,
wherein the further electrically insulating layer structure has a thickness smaller than five times, in particular three times, more in particular two times, the thickness (T1) of the at least one electrically conductive layer structure (104).

10. The component carrier (100) according to one of the preceding claims, further comprising at least one of the following features:
wherein the at least one electrically conductive layer structure (104) is a discontinuous layer structure comprising electrically conductive portions (105, 106), and
wherein the dummy body (150) is arranged between at least two of said electrically conductive portions (105, 106);
wherein the dummy body (150) partially surrounds at least one of said electrically conductive portions (105, 106) of the at least one electrically conductive layer structure (104),
in particular wherein the dummy body (150) and the electrically conductive portions (105, 106) are spaced by electrically insulating material;
wherein the dummy body (150) comprises a planar profile, and
wherein said planar profile comprises at least one concave portion that partially surrounds at least one of the electrically conductive portions (105, 106).

11. The component carrier (100) according to one of the preceding claims, comprising at least one of the following features:
wherein the dummy body (150) is embedded, in particular sandwiched, between two of the plurality of electrically insulating layer structures (102, 108);
wherein the dummy body (150) is plate-shaped, in particular comprising two opposed main surfaces;
wherein the dummy body (150) is fully enclosed by electrically insulating material of the plurality of electrically insulating layer structures (102, 108) of the stack (101).

12. The component carrier (100) according to one of the preceding claims, comprising at least of the following features:
wherein the dummy body (150) is embedded in an active portion of the stack (101);
wherein the free region (150) is an active portion of the stack (101);
wherein a density of electrically conductive portions (105, 106) in the proximity of the dummy body (150) and/or the free region (130) is lower than in other regions of the stack (101);
wherein the planar distance between two electrically conductive portions (105, 106) is larger than 5 mm;
wherein the free region (130) is larger than 90 mm².

13. The component carrier (100) according to one of the preceding claims,
wherein the at least one electrically insulating layer structure is configured as a core layer, and
wherein the dummy body (150) is in contact with the core layer; in particular
wherein one of the plurality of electrically insulating layer structures (102, 108), in particular the core layer, is sandwiched by at least two dummy bodies (150, 152); or
wherein at least two dummy bodies (150, 152) are embedded in the same electrically insulating layer structure (102, 108) and/or at least partially on top of each other in the vertical direction,
in particular wherein the at least two dummy bodies (150, 152) are vertically spaced only by at least part of one of the plurality of electrically insulating layer structures (102, 108), in particular the core layer,
in particular
wherein the dummy body (150) comprises a material different to the material of the plurality of electrically insulating layer structures (102, 108); and/or wherein the at least two dummy bodies (150, 152) comprise a different material, in particular with respect to a resin and/or a filler and/or a cured state.

14. The component carrier (100) according to one of the preceding claims,
wherein the dummy body (150) is provided as a cured resin, reflected in the component carrier (100) by an interface region of the dummy body (150) and the surrounding electrically insulating material.

15. A method of manufacturing a component carrier (100), wherein the method comprises:
forming a stack (101) comprising at least one electrically conductive layer structure (104) and a plurality of electrically insulating layer structures (102, 108);
defining a free region (130), being free of the at least one electrically conductive layer structure (104); and
embedding a dummy body (150) in the stack (101), wherein the dummy body (150) is provided on or in at least one of the plurality of electrically insulating layer structures (102, 108), and wherein the dummy body (150) fills the free region (130).
